Europäisches Patentamt

European Patent Office

Office européen des brevets

(19)

(11) Veröffentlichungsnummer: 0 048 829
A2

# (12) EUROPÄISCHE PATENTANMELDUNG

(21) Anmeldenummer: 81106750.3

(22) Anmeldetag: 29.08.81

(51) Int. Cl.³: H 01 L 31/18, H 01 L 31/02, H 01 L 21/60

(30) Priorität: 26.09.80 DE 3036260

(43) Veröffentlichungstag der Anmeldung: 07.04.82
Patentblatt 82/14

(84) Benannte Vertragsstaaten: FR GB IT NL

(71) Anmelder: Licentia Patent-Verwaltungs-GmbH,
Theodor-Stern-Kai 1, D-6000 Frankfurt/Main 70 (DE)

(72) Erfinder: Dahlberg, Reinhard, Dr., Innere Bergstrasse 32,
D-7101 Flein (DE)

(74) Vertreter: Langer, Karl-Heinz, Dipl.-Ing. et al, Licentia
Patent-Verwaltungs-GmbH Theodor-Stern-Kai 1,
D-6000 Frankfurt/Main 70 (DE)

(54) Verfahren zur Herstellung von elektrischen Kontakten an einer Silizium-Solarzelle.

(57) Bei einem Verfahren zur Herstellung von elektrischen Kontakten an einer Silizium-Solarzelle wird eine Metallfolie, die auf einer Seite eines Trägers haftet, zusammen mit dem Träger in Form der Kontakte ausgestanzt. Die ausgestanzte Kontaktfolie wird so auf das Silizium aufgebracht, daß sie sich vom Träger löst und auf der Silizium-Oberfläche haftet.

EP 0 048 829 A2

0048829

Licentia Patent-Verwaltungs-G.m.b.H.
Theodor-Stern-Kai 1, 6000 Frankfurt 70

Heilbronn, den 19.09.80
SE2-HN-La/lü - HN 80/46

## Verfahren zur Herstellung von elektrischen Kontakten an einer Silizium-Solarzelle

Die Herstellung von Kontakten an einer Silizium-Solarzelle wird heute noch meistens mit Hilfe von im Hochvakuum aufgedampften und eingetemperten Schichten aus Metallen durchgeführt. Da das Hochvakuum-Aufdampfverfahren relativ kostenaufwendig ist, ist auch schon vorgeschlagen worden, Kontakte an Solarzellen durch Aufspritzen von Metallen mit Hilfe eines Plasmastrahlverfahrens durchzuführen. Auch ein Aufbringen der elektrischen Kontakte mit Hilfe des sogenannten Sieberdruckverfahrens wird praktiziert. Allen Verfahren gemeinsam ist, daß ein Teil des aufzuwendenden Materials für die Kontakte verlorengeht und daß die Verfahren relativ aufwendig sind.

Die vorliegende Erfindung beschreibt ein Verfahren zur Herstellung von elektrischen Kontakten an Solarzellen, bei welchem das nicht für die Kontakte benötigte Kontaktmaterial vollständig wieder gewonnen werden kann. Es ist außerdem in seinem Aufwand kostengünstiger als alle anderen bekannten Verfahren. Das Verfahren zur Herstellung von elektrischen Kontakten an einer Silizium-Solarzelle besteht nach der Erfindung darin, daß eine Metallfolie, die auf einer Seite eines Trägers haftet, zusammen mit dem Träger in Form der Kontakte ausgestanzt und die ausgestanzte Kontaktfolie so auf das Silizium aufgebracht wird, daß sie sich vom Träger löst und auf der Silizium-Oberfläche haftet.

Die auf der Oberfläche des Siliziums haftende Kontaktfolie kann anschließend in einer geeigneten Atmosphäre eingesintert oder einlegiert werden. Als Kontakt-Materialien für die Silizium-Solarzellen eignen sich Folien aus Aluminium, Aluminium-Silizium-Legierungen, Eisen-Silizium-Legierungen, Zinn, Blei, Kupfer, Antimon, Arsen, Zink oder aus Legierungen dieser Metalle miteinander. Das Sintern oder Einlegieren der auf die Siliziumoberfläche aufgebrachten, ausgestanzten Kontaktfolie geschieht vorzugsweise in einer reduzierenden Atmosphäre, z. B. in einem Durchlaufofen. Das Sintern oder Einlegieren der Kontaktfolie kann jedoch auch durch kurzzeitiges Erhitzen mit Hilfe eines fokussierten Lichtstrahls oder eines Lasers erfolgen. Es ist in der Praxis auch vorteilhaft, die auf der Silizium-Fläche haftende Kontaktfolie beim Legierungsvorgang mechanisch an die Silizium-Oberfläche anzudrücken.

Die Erfindung wird in den folgenden Ausführungsbeispielen näher beschrieben.

## Ausführungsbeispiel 1

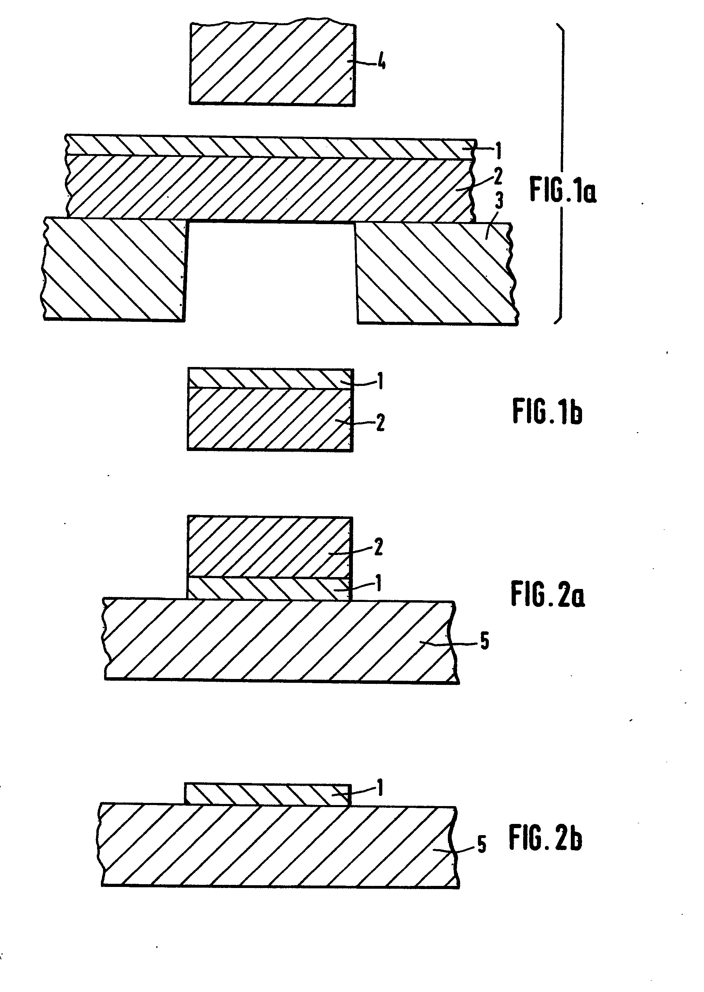

In Fig. 1a ist 1 eine Folie aus einer Aluminium-Silizium-Legierung, welche mit Hilfe der Matrize 3 und dem Stempel 4 gestanzt wird. Fig. 1b zeigt das Stanzteil aus Träger 2 und Folie 1.

## Ausführungsbeispiel 2

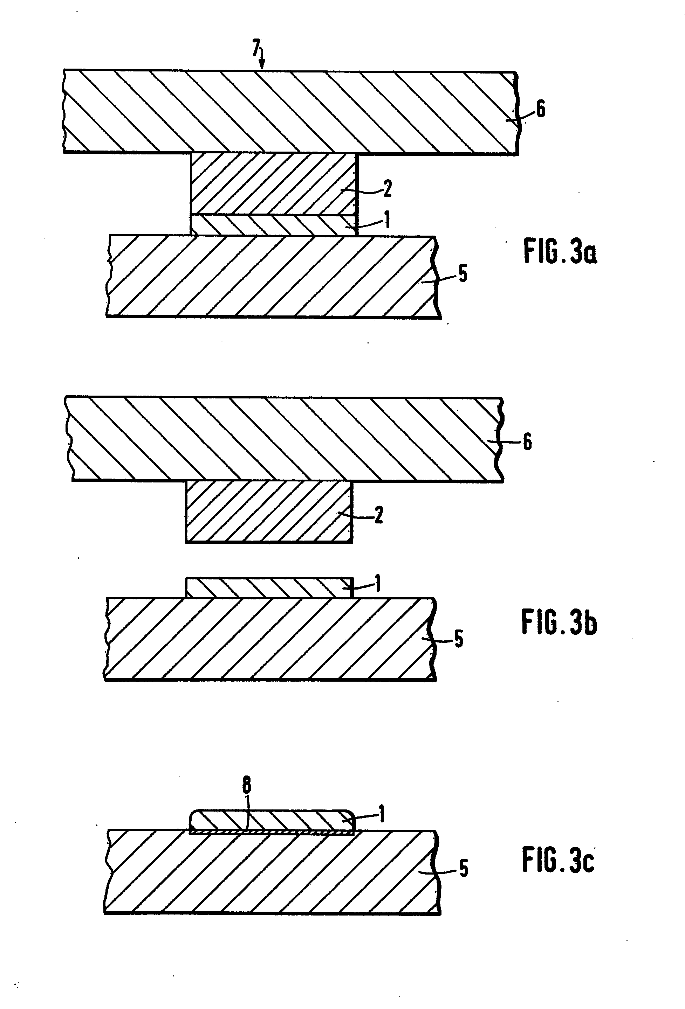

In Fig. 2a ist ein Stanzteil aus Träger 2 und Metallfolie 1 mit der Metallseite auf eine Silizium-Solarzelle gelegt. In Fig. 2b ist der Träger 2 von der Metallfolie 1 abgelöst. Die Metallfolie 1 haftet auf der Oberfläche der Solarzelle 5.

0048829

Ausführungsbeispiel 3

In Fig. 3a ist ein Stanzteil 2 mit der Metallfolie 1 auf die Oberfläche einer Silizium-Solarzelle 5 gelegt. Das Stanzteil 2 haftet auf dem Transportband 6. Zwischen Solarzelle 5 und dem Transportband 6 liegt der mechanische Druck 7.

In Fig. 3b wird das Transportband 6 von der Solarzelle 5 getrennt. Der Träger 2 haftet am Transportband 6, und die Metallfolie 1 haftet auf der Oberfläche der Solarzelle 5.

In Fig. 3c ist die Solarzelle 5 zusammen mit der Metallfolie 1 über die Legierungstemperatur erhitzt worden, so daß sich die Legierungszone 8 ausgebildet hat.

Bezugsziffern

1    Metallfolie

2    Träger

3    Matrize

4    Stempel

5    Silizium-Solarzelle

6    Transportband

7    Mechanischer Druck

8    Legierungszone

Licentia Patent-Verwaltungs-G.m.b.H. 0048829
Theodor-Stern-Kai 1, 6000 Frankfurt 70

Heilbronn, den 19.09.80
SE2-HN-La/lü - HN 80/46

Patentansprüche

1) Verfahren zur Herstellung von elektrischen Kontakten an einer Silizium-Solarzelle, dadurch gekennzeichnet, daß eine Metallfolie, die auf einer Seite eines Trägers haftet, zusammen mit dem Träger in Form der Kontakte ausgestanzt wird, und daß die ausgestanzte Kontaktfolie so auf das Silizium aufgebracht wird, daß sie sich vom Träger löst und auf der Silizium-Oberfläche haftet.

2) Verfahren nach Anspruch 1, dadurch gekennzeichnet, daß die auf der Silizium-Oberfläche befindliche Folie in einer reduzierenden Atmosphäre auf das Silizium aufgesintert oder auflegiert wird.

3) Verfahren nach Anspruch 1 oder 2, dadurch gekennzeichnet, daß die Folie auf dem Silizium während des Sinter- oder Legiervorganges unter mechanischem Druck gegen das Silizium gepreßt wird.

4) Verfahren nach einem der vorhergehenden Ansprüche, dadurch gekennzeichnet, daß als Legierungsmaterialien Aluminium, Aluminium-Silizium-Legierungen, Eisen-Silizium-Legierungen, Zinn, Blei, Kupfer, Antimon, Arsen, Zink oder Legierungen dieser Metalle untereinander verwendet sind.

5) Verfahren nach einem der vorhergehenden Ansprüche, dadurch gekennzeichnet, daß die Folie aus dem Legierungsmaterial auf dem Silizium durch kurzzeitiges Aufheizen mit Hilfe eines fokussierten Licht- oder Laser-Strahls aufgesintert oder aufgeschmolzen wird.

0048829

6) Verfahren nach einem der vorhergehenden Ansprüche, dadurch gekennzeichnet, daß die ausgestanzte Folie aus Kontakt-Material zusammen mit dem ausgestanzten Träger auf einem Transportband haftend aufbewahrt, transportiert oder verarbeitet wird.

7) Verfahren nach einem der vorhergehenden Ansprüche, dadurch gekennzeichnet, daß als Material für Träger und Transportband ein organischer Kunststoff verwendet wird.

FIG.1a

FIG.1b

FIG.2a

FIG.2b

FIG.3a

FIG.3b

FIG.3c